(19) **Europäisches Patentamt**
**European Patent Office**
**Office européen des brevets**

(11) **EP 1 741 801 B1**

(12) **EUROPEAN PATENT SPECIFICATION**

(45) Date of publication and mention
of the grant of the patent:
**12.08.2009 Bulletin 2009/33**

(51) Int Cl.:
**C23C 14/06** *(2006.01)*  **C23C 14/35** *(2006.01)*

(21) Application number: **06011694.4**

(22) Date of filing: **06.06.2006**

(54) **Method for forming amorphous carbon film**

Verfahren zum Herstellen einer amorphen Kohlenstoffschicht

Procédé de fabrication d'une couche de carbone amorphe

(84) Designated Contracting States:
**AT DE FR NL SE**

(30) Priority: **04.07.2005 JP 2005195303**

(43) Date of publication of application:
**10.01.2007 Bulletin 2007/02**

(73) Proprietor: **KABUSHIKI KAISHA KOBE SEIKO SHO**
**Kobe-shi,**
**Hyogo 651-8585 (JP)**

(72) Inventor: **Yamamoto, Kenji**
**1-chome**
**Nishi-ku**
**Kobe-shi**
**Hyogo 651-2271 (JP)**

(74) Representative: **Müller-Boré & Partner**
**Patentanwälte**
**Grafinger Strasse 2**
**81671 München (DE)**

(56) References cited:
**JP-A- 2001 150 351       JP-A- 2003 247 060**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This invention relates to a method for forming an amorphous carbon film, and in particular, to a method for forming an amorphous carbon film, used in sliding parts of machine components, and so forth.

An amorphous carbon film (hereinafter referred to also as a DLC film) has high hardness and a smooth surface, and exhibits self-lubricity, so that it is used in machine components, and is lately put to use for dry-cutting of non-ferrous metal tools.

In general, a method for forming (film-deposition) the DLC film is broadly classified into a method for effecting the film-deposition from a gaseous material of a carbon-containing gas (methane, ethylene, benzene, and so forth) source by a plasma CVD process, and a method for effecting the film-deposition by a sputtering or arc process using a solid carbon supply source.

In the case of the latter method, there exists a problem in that a deposition rate is low because the solid carbon supply source has a low sputtering rate, so that the method is faced with a task for enhancing the deposition rate. Accordingly, a method has been attempted (JP - A No. 247060 / 2003) whereby not only the solid carbon supply source, but also a carbon-containing hydrocarbon gas are introduced into a chamber at the time of film-deposition by sputtering so as to directly ionize the hydrocarbon gas by the agency of plasma, thereby increasing a deposition rate (speed). However, as enhancement in the deposition rate was found still insufficient, further improvement in the deposition rate is hoped for.

The invention has been developed under the circumstances, and its object is to provide a method for forming an amorphous carbon film, capable of enhancing a deposition rate of the amorphous carbon film to thereby implementing deposition of the amorphous carbon film at a high speed.

The inventors, et. al have conducted strenuous studies in order to attain the object as described, and as a result, have succeeded in achieving the present invention.

One aspect of the invention is directed to a method for forming an amorphous carbon film, having the steps of: preparing at least two units of unbalancedmagnetron sputtering evaporation sources, or at least one unit each of the unbalanced magnetron sputtering evaporation source and a magnetic field applied arc-discharge evaporation source, and using a solid carbon as a sputtering target material of at least one unit of the unbalanced magnetron sputtering evaporation source among the evaporation sources to thereby turn an atmosphere into an atmosphere of a mixed gas of an inert gas for sputtering and a carbon-containing gas. In this method, respective magnetic fields of the evaporation sources are reversed in polarity from a magnetic field of the evaporation source adjacent to the respective evaporation sources, and a pulse potential at a frequency in a range of 50 to 400 kHz is imparted to the respective unbalanced magnetron sputtering evaporation sources.

The method for forming an amorphous carbon film is further characterized in that the pulse potential is imparted at a duty cycle in a range of 50 to 80 %.

According to the aspect of the invention, the method for forming the amorphous carbon film makes it possible to enhance a deposition rate of the amorphous carbon film, and thereby forming the amorphous carbon film at a high speed.

Embodiments of the present invention will be described in detail based on the following figures, wherein:

Fig. 1 is a schematic diagram showing an example of an apparatus for carrying out a method for forming an amorphous carbon film according to an embodiment {(A) of Example 1} of the invention;
Fig. 2 is a schematic diagram showing an example of an apparatus for carrying out a method for forming an amorphous carbon film according to a comparative example;
Fig. 3 is a schematic diagram showing an example of an apparatus for carrying out a method for forming an amorphous carbon film according to another embodiment (Example 3) of the invention;
Fig. 4 is a schematic diagram showing an example of a film-forming apparatus using unbalanced magnetron sputtering evaporation sources; and
Fig. 5 is a diagram showing a recurring waveform of a pulse potential when the pulse potential is imparted to a target.

The inventors, et. al have conducted strenuous studies to attain the obj ect as described, and as a result, have succeeded in finding out that when depositing a DLC film by a sputtering method using a solid carbon for each of sputtering target materials of unbalanced magnetron sputtering evaporation sources, respective magnetic fields of the evaporation sources are reversed in polarity from a magnetic field of the evaporation source adjacent to the respective evaporation sources while hydrocarbon is introduced into a film-forming atmosphere, and a pulse potential at a frequency in a range of 50 to 400 kHz is applied to the respective evaporation sources so as to enable a film-deposition rate of the DLC film (an amorphous carbon film) to be enhanced, thereby depositing the DLC film at a high speed.

The invention has been achieved based on such knowledge as described above, adopting a method for forming an amorphous carbon film, comprising process steps described as above. More specifically, the method for forming the amorphous carbon film, according to the invention, is a method for forming an amorphous carbon film, comprising the steps of preparing at least two units of unbalanced magnetron sputtering evaporation sources, or at least one unit each of the unbalanced magnetron sputtering evaporation source, and a magnetic field applied arc-discharge evaporation source, and using a solid carbon as a sputtering target material of at least one unit of the unbalanced magnetron sputtering evaporation source among those evaporation sources to thereby turn an atmosphere into an atmosphere of a mixed gas of an inert gas for sputtering and a carbon-containing gas so as to form the amorphous carbon film, wherein respective magnetic fields of the those evaporation sources are reversed in polarity from the magnetic field of the evaporation source adjacent to the respective evaporation sources, and the pulse potential at the frequency in the range of 50 to 400 kHz is imparted to the respective unbalanced magnetron sputtering evaporation sources.

As is evident from the knowledge described as above, with this method for forming the film (the method for forming the amorphous carbon film, according to the invention), it is possible to enhance the film-deposition rate of the DLC film (the amorphous carbon film) to thereby deposit the DLC film at a high speed.

The method for forming the amorphous carbon film, according to the invention, is described in more details hereinafter.

In the case of a magnetron sputtering method, there is formed a space enclosed by lines of magnetic force in space in front of a target by the agency of magnets disposed on the back surface of the target. Electrons in plasma are trapped by the lines of magnetic force, and undergo cyclotron movement to thereby enhance probability of collision of the electrons with the inert gas, which is a sputter gas, that is, a noble gas (commonly, Ar), accelerating ionization of the noble gas element. If a hydrocarbon gas (for example, $CH_4$), in addition to the noble gas, is introduced into the atmosphere at this point in time, the hydrocarbon gas also collides with the electrons, whereupon parts of the hydrocarbon gas undergo ionization to be thereby deposited as the DLC film on a substrate. In the case of using the solid carbon for the target, a sum of carbon sputtered from the target by the agency of the ionized element of the noble gas, and ionized parts of the hydrocarbon gas, as deposited, is recognized as the deposition rate of the DLC film.

In such a mode of deposition of the DLC film, the deposition rate of the DLC film can be increased by applying a pulse potential. If the pulse potential is applied, this will cause a cyclically varying electric field to be produced in front of the target. The electrons trapped by the lines of the magnetic force in front of the target undergo vibration movement by the agency of the cyclically varying electric field while making the cyclotron movement. As the probability of the collision of the electrons with an atmospheric gas (the noble gas + the hydrocarbon gas) will further increase due to the vibration movement, it is deemed that ionization of the hydrocarbon gas is accelerated, and the ionization of the noble gas element is further accelerated to thereby increase sputtering from the carbon as the target, resulting in an increase in the deposition rate.

As the velocity of electron transfer in a vacuum is very high, and the higher the frequency of the applied pulse potential is, the greater the number of electron vibrations becomes, thereby accelerating ionization of the gas, however, an effect of such ionization acceleration will reach saturation at a frequency in the neighborhood of 400 kHz, so that the upper limit of the frequency of the pulse potential is set to 400 kHz. On the other hand, if the frequency of the pulse potential is at 50 kHz or lower, the number of the electron vibrations decreases, and the effect of the ionization acceleration is not recognizable, so that the lower limit of the frequency of the pulse potential is set to 50 kHz. Further, the frequency of the pulse potential is preferably not lower than 100 kHz, and more preferably not lower than 200 kHz. The pulse potential to be applied may be either at a unipolar pulse undergoing variation between a minus potential and zero, or a bipolar pulse undergoing variation between a minus potential and a plus potential. For the carbon-containing gas used in film-deposition, use can be made of gasses such as $CH_4$, $C_2H_2$, $C_2H_4$, $C_6H_6$, and so forth. As to pressure at the time of the film-deposition, a total pressure is preferably from 0.2 to 1 Pa, and a partial pressure of the hydrocarbon gas is preferably from 0.02 to 0.1 Pa.

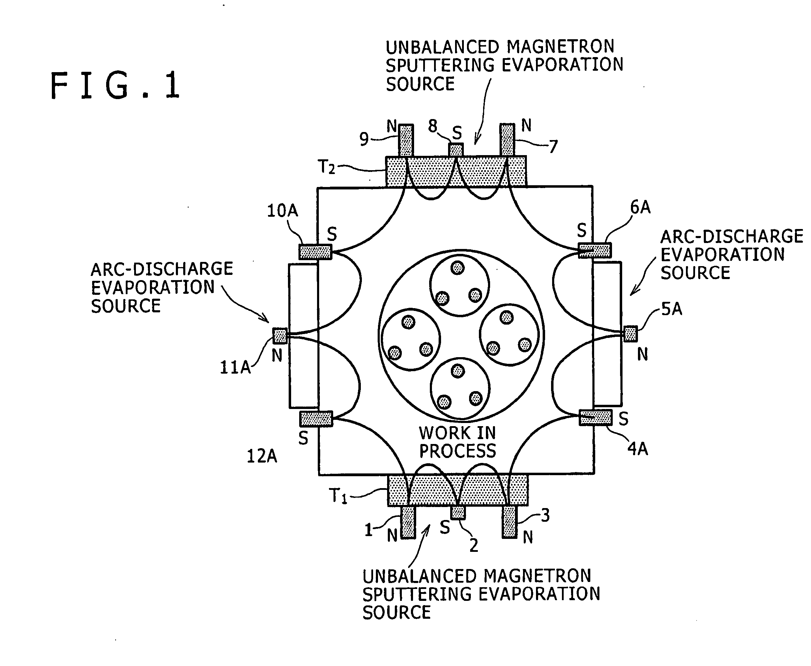

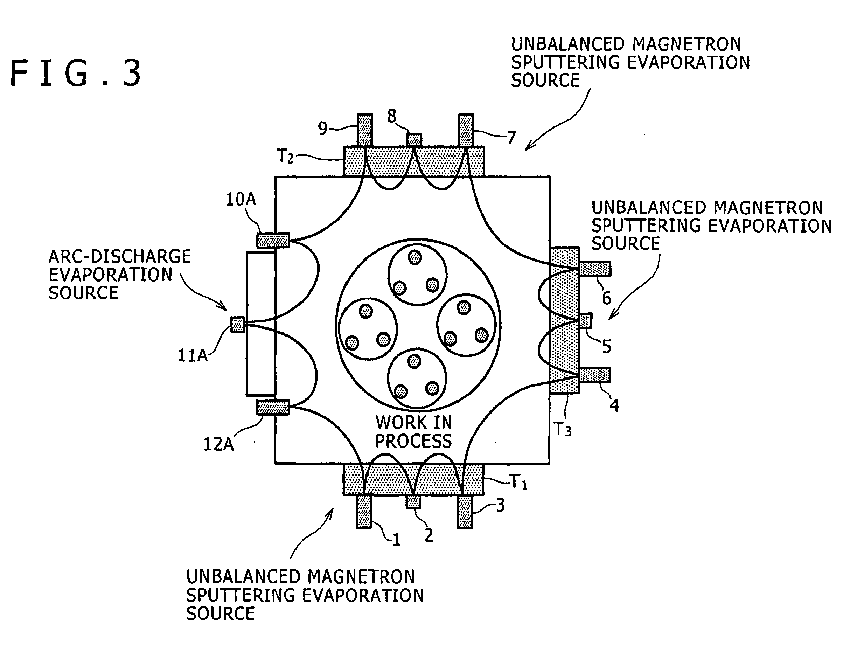

In the case of a layout of magnetic fields of a magnetron sputtering source, where magnetic poles on the outer side are stronger in intensity than a magnetic pole on the inner side, that is, in the case of an unbalanced layout of magnetic fields, parts of electrons move forward along lines of magnetic force to reach as far as the neighborhood of the substrate, and collide with the gas in the neighborhood of the substrate, thereby producing plasma. In the case of such an unbalanced magnetron layout, the electrons also undergo vibration movement by the agency of a pulsing electric field, but a ratio of electrons present in the vicinity of the substrate is high, so that an effect of an increase in the deposition rate, due to the ionization of the hydrocarbon gas, is higher in comparison with that in the case of a common magnetron layout. That is, in the case of using the unbalanced magnetron sputtering evaporation sources, the effect of an increase in the deposition rate, due to the ionization of the hydrocarbon gas, is higher than that in the case of using a magnetron sputtering evaporation source . Figs. 1 to 4 each show a film-forming apparatus using the unbalanced magnetron sputtering evaporation sources by way of example. With any of the unbalanced magnetron sputtering evaporation sources shown in Figs. 1 to 4, respectively, two pieces of magnets (magnetic poles), that is, one magnet at the center and the other magnet in a ring-like shape, surrounding the one magnet, are disposed on the back surface of an evaporation source (sputtering target), and magnet parts 1, 3 (parts of the magnet in ring-like shape, on the outer sides thereof, as seen in section), disposed in the vicinity of respective ends of the evaporation source, each are greater in magnetic field strength than a magnet 2 (the magnet at the center) disposed at the center of the evaporation source. Further, with the film forming apparatus shown in Figs. 1 to 3, respectively, magnet parts 7, 9 (parts of a magnet in ring-like shape, on the outer sides thereof, as seen in section) each are greater in magnetic field strength than a magnet 8 (a magnet at the center). Furthermore, with the film forming apparatus shown in Fig. 3, magnet parts 4, 6 (parts of a magnet in ring-like shape, on the outer sides thereof, as seen in section) each are greater in magnetic field strength than a magnet 5 (a magnet at the center). Contrary to the magnetic field layout described as above, in the case of the magnetron sputtering evaporation source, all magnets (magnet parts on the outer sides as seen in section and a magnet at the center) are equivalent to, or substantially equivalent to each other in magnetic field strength. In Figs. 1 to 4, T1, T2, T3 indicate sputtering targets, respectively.

With the film-forming apparatus comprising at least two units of the unbalancedmagnetron sputtering evaporation sources, or at least one unit each of the unbalanced magnetron sputtering evaporation source, and the magnetic field applied arc-discharge evaporation source, if the respective magnetic fields of the evaporation sources are reversed in polarity from the magnetic field of the evaporation source adjacent to the respective evaporation sources, lines of magnetic forces of the evaporation sources adjacent to each other come to be joined together as shown in Figs. 1 and 3 by way of example. In the case of an example shown in Fig. 1, assuming that the magnet part (magnetic pole) 3 is the N-pole, a magnet par 4A adjacent thereto is the S-pole, the magnet parts 3, 4 are reversed in polarity from each other (being not the same in polarity, but opposite to each other in polarity), a magnet part 6A (the S-pole) and the magnet part 7 (the N-pole) are reversed in polarity from each other, the magnet part 9 (the N-pole) and a magnet part 10A (the S-pole) are reversed in polarity from each other, and a magnet part 12A (the S-pole), and the magnet part 1 (the N-pole) are reversed in polarity from each other. Thus, if the respective magnetic fields of the evaporation sources are reversed in polarity from the magnetic field of the evaporation source adjacent to the respective evaporation sources, lines of the magnetic force of the magnet part (magnetic pole) 3 come to be joined with lines of the magnetic force of the magnet part 4A, lines of the magnetic force of the magnet part 6A come to be joined with lines of the magnetic force of the magnet part 7, lines of the magnetic force of the magnet part 9 come to be joined with lines of the magnetic force of the magnet part 10A, and lines of the magnetic force of the magnet part 12A come to be joined with lines of the magnetic force of the magnet 1.

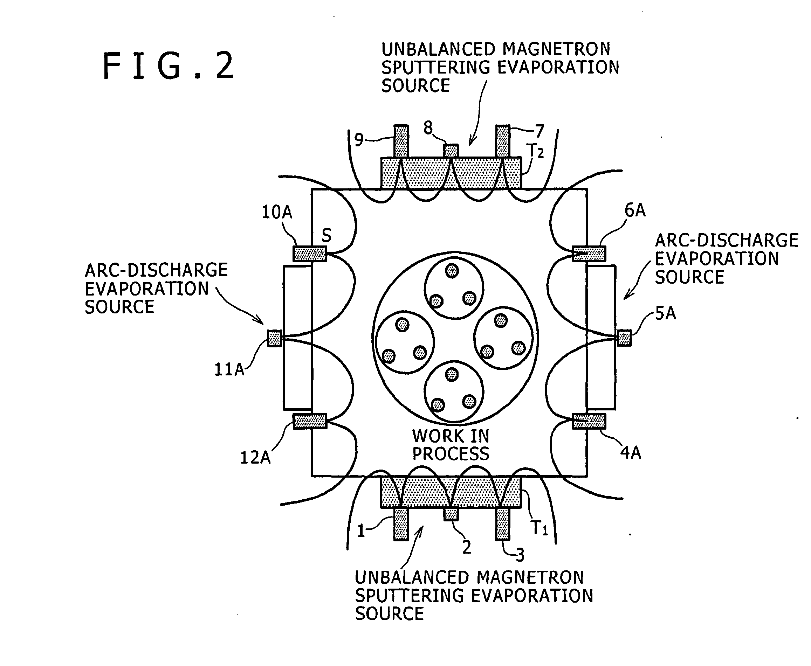

When the respective magnetic fields of the evaporation sources are reversed in polarity from the magnetic field of the evaporation source adjacent to the respective evaporation sources, thereby causing the lines of the magnetic forces of the evaporation sources adjacent to each other to be joined together as described above, the ionization of the hydrocarbon gas is accelerated, resulting in significant enhancement of the deposition rate. The reason for that is described hereinafter. More specifically, during glow discharge in sputtering, electrons ejected from the target (a cathode) stream toward an anode (a chamber), whereupon the electrons are guided toward the vicinity of the substrate inside the chamber because there exist no lines of magnetic force directed toward the chamber if the evaporation sources are disposed such that the lines of the magnetic forces of the evaporation sources adjacent to each other are joined together, so that the effect of accelerating the ionization of the hydrocarbon gas becomes significant. In contrast, in the case where the evaporation sources are disposed such that the lines of the magnetic forces of the evaporation sources adj acent to each other are not joined together, as shown in Fig. 2 by way of example, the lines of the magnetic forces point directly toward the wall of the chamber acting as the anode, so that the electrons quickly reach the anode, thereby rendering the effect of accelerating the ionization of the hydrocarbon gas to become insignificant.

As described in the foregoing, by reversing polarities of the respective magnetic fields of the evaporation sources from that of the magnetic field of the evaporation source adjacent to the respective evaporation sources, and by providing the respective unbalanced magnetron sputtering evaporation sources with the pulse potential at the frequency in the range of 50 to 400 kHz, the deposition rate of the DLC film is considerably enhanced. Accordingly, with the method for forming the amorphous carbon film, according to the invention, the deposition rate of the DLC film (the amorphous carbon film) can be sharply enhanced to thereby deposit the DLC film at a high speed.

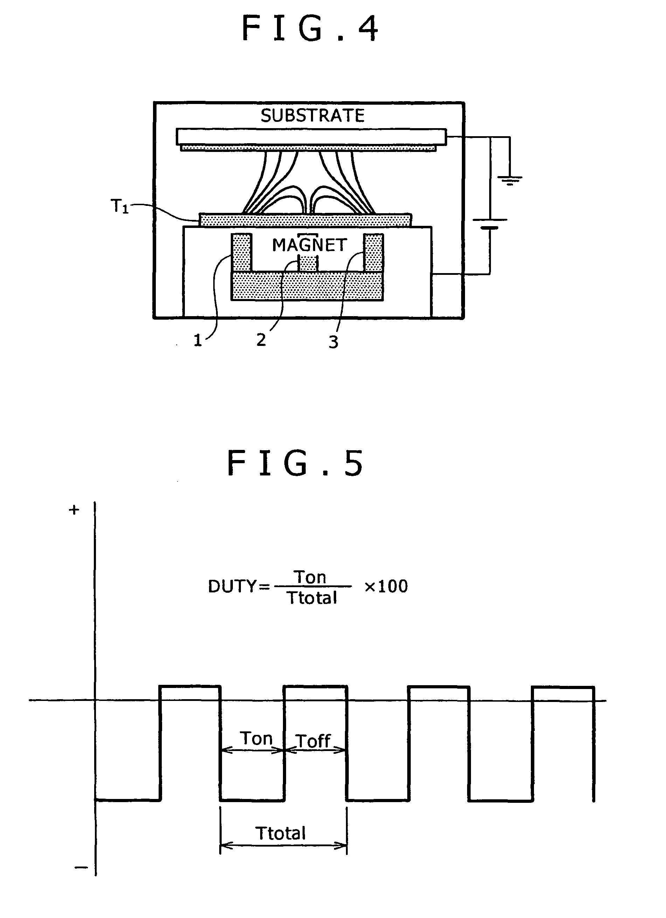

With the method for forming the amorphous carbon film, according to the invention, the pulse potential is preferably imparted at a duty cycle in a range of 50 to 80 % (a second invention) . By so doing, the deposition rate of the DLC film can be enhanced at a high level with greater reliability to thereby deposit the DLC film at a high speed. This will be described in more details hereinafter. In the case of setting the duty cycle to 50 % or higher upon imparting the pulse potential, an increase in the deposition rate is recognized. More specifically, when a voltage is at 0V, or at a plus potential in the case of the bipolar pulse, no potential in effect occurs to the target, so that sputtering does not occur to the target. Accordingly, in the case of the duty cycle being less than 50 %, the effect of an increase in the deposition rate is small. Then, in the case of the duty cycle exceeding 80 %, there is an increase in time when a potential becomes constant during $T_{on}$ shown in Fig. 5, so that there is a decrease in the effect of the ionization due to the electron vibration, thereby rendering a measure of enhancement in the deposition rate to become small. Hence, the duty cycle is preferably set to the range of 50 to 80 %, and if the duty cycle is set to the range of 50 to 80 %, the deposition rate of the DLC film can be enhanced at a high level with greater reliability. From the viewpoint of the enhancement in the deposition rate, the duty cycle is more preferably set to a range of 60 to 75 %. Incidentally, the duty cycle (%) refers to a ratio of a load time period to one cycle of a recurring waveform. The duty cycle (%) upon imparting the pulse potential to the target is a ratio of a potential load time period (a time period during which a potential is kept occurring to the target) to one cycle of the recurring waveform of the pulse potential. The duty cycle is diagrammatically shown in Fig. 5 by way of for example. With the recurring waveform shown in Fig. 5, assuming that $T_{total}$ is one cycle of the recurring waveform of the pulse potential, and $T_{on}$ the potential load time period during the one cycle, the following holds:

$$\texttt{the duty cycle (\%) = ($T_{on}$ / $T_{total}$) x 100}$$

With the method for forming the amorphous carbon film, according to the invention, there are prepared at least two units of the unbalanced magnetron sputtering evaporation sources, or at least one unit each of the unbalanced magnetron sputtering evaporation source, and the magnetic field applied arc-discharge evaporation source, and the solid carbon is used as the sputtering target material of at least one unit of the unbalanced magnetron sputtering evaporation source among those evaporation sources. Accordingly, there are included: a case (a) where the solid carbon is used for only one unit of the unbalanced magnetron sputtering evaporation source; a case (b) where the solid carbon is used for several units of the unbalanced magnetron sputtering evaporation sources as well, other than the one unit of the unbalanced magnetron sputtering evaporation source; and a case (c) where the solid carbon is used for all units of the unbalanced magnetron sputtering evaporation sources; and any of those cases are to be construed within the scope of the method for forming the amorphous carbon film, according to the invention.

In the cases (a) and (b) as above, metal, ceramics, and so forth may be used for the evaporation sources other than the evaporation source or sources, using the solid carbon.

In the case (c) where the solid carbon is used for all the units of the evaporation sources, the DLC film (amorphous carbon film) composed of the amorphous carbon only can be obtained. In the cases (a) and (b) as above, if metal is used for the evaporation sources other than the evaporation source or sources using the solid carbon, the DLC film (amorphous carbon film) containing the metal evaporated from the evaporation sources can be obtained, and if ceramics is used for the evaporation sources other than the evaporation source or sources using the solid carbon, the DLC film (amorphous carbon film) containing the ceramics evaporated from the evaporation sources can be obtained.

The magnetic field applied arc-discharge evaporation source refers to an arc-discharge evaporation source provided with magnets so as to enable magnetic fields to be applied thereto. The same is an evaporation source where the magnets are disposed to thereby produce the magnetic fields, such as, for example, an arc-discharge evaporation source shown in Fig. 1. The arc-discharge evaporation source refers to a type of evaporation source, causing evaporation to occur by arc discharge.

Embodiments

Working examples according to embodiments of the invention, and comparative examples are described hereinafter.

**[Example 1]**

(A) With the use of the film-forming apparatus comprising the unbalanced magnetron sputtering evaporation sources (2 units), and the arc-discharge evaporation source (2 units), as shown in Fig. 1, deposition of a DLC film (an amorphous carbon film) in an atmosphere of a mixed gas of argon and a hydrocarbon gas was carried out in a pulse mode (with a pulse potential imparted thereto).

In this case, a chromium metal target for forming an intermediate layer was used for one unit of the evaporation source of the unbalanced magnetron sputtering evaporation sources (2 units), and a solid carbon target was used for the other unit of the evaporation source. Further, a layout was adopted such that respective magnetic fields of the evaporation sources are reversed in polarity from a magnetic field of the evaporation source adjacent to the respective evaporation sources, thereby causing lines of magnetic forces of the evaporation sources adjacent to each other to be joined together, as shown in Fig. 1.

For a matrix, use was made of a silicon wafer used for measurement of a deposition rate. An input power for sputtering was set to 2 kW at a pulse peak. A chromium metal film (100 nm) as the intermediate layer was formed on the silicon wafer. An atmosphere at the time of forming the intermediate layer composed of Cr was an argon atmosphere at a pressure of 0.6 Pa. At the time of the deposition of the DLC film, a total pressure at 0.6 Pa was kept constant while a hydrocarbon gas was introduced at 10 % of a volumetric ratio (a ratio of the volume of the hydrocarbon gas to the volume of Ar together with the hydrocarbon gas), namely, at a partial pressure of 0.06 Pa, thereby having formed the DLC film. A voltage applied to a substrate upon film-deposition was set to 50 V at the time of forming the intermediate layer composed of Cr, and to 100 V at the time of forming the DLC film.

The silicon wafer with both the intermediate layer composed of Cr and the DLC film deposited thereon was cut, and the cross-section thereof was observed by an SEM in a magnification range of 10,000 to 20,000 x, to thereby find a film thickness of the DLC film. Then, the deposition rate (film-forming speed) of the DLC film was found by computation on the basis of a film thickness of the DLC film, and film-deposition time.

(B) In place of the pulse mode as under item (A) as above, a DC mode (without a pulse potential imparted; an input power is kept constant) was adopted, and an input power for sputtering was at 2 kW. Further, there was not adopted the layout where the respective magnetic fields of the evaporation sources are reversed in polarity from the magnetic field of the evaporation source adjacent to the respective evaporation sources (thereby causing the lines of the magnetic forces of the evaporation sources adjacent to each other to be joined together), as in the case of item (A) as above. That is, the respective magnetic fields of the evaporation sources are rendered the same in polarity as the magnetic field of the evaporation source adjacent to the respective evaporation sources, thereby causing the lines of the magnetic forces of the evaporation sources adjacent to each other not to be joined together, as shown in Fig. 2.

Deposition of an intermediate layer composed of Cr and a DLC film was carried out in the same manner as in the case of item (A) as above, except for those points described, and subsequently, in the same manner as in the case of item (A) as above, measurement of a film thickness of the DLC film was executed by observation of the cross section thereof while a deposition rate of the DLC film was computed.

(C) Results of measurements described as above (the deposition rate of the DLC film, as found), together with film-forming conditions, are shown in Table 1. As is evident from Table 1, the deposition rate of the DLC film in the respective cases (working examples) of Nos. 4 to 8, and No. 11 is found higher in comparison with that in the respective cases (comparative examples) of Nos. 1 to 3, Nos. 9, 10, and Nos. 12 to 15, showing that the DLC film is formed at high speeds, respectively.

## [Example 2]

A duty cycle upon impartation of a pulse potential at the time of deposition of a DLC film was varied. The deposition of an intermediate layer composed of Cr and a DLC film was carried out in the same manner as in the case of the example 1 (A) as above, except for a point described, and subsequently, in the same manner as in the case of the example 1 (A) as above, measurement of a film thickness of the DLC film was executed by observation of the cross section thereof while a deposition rate of the DLC film was computed. Further, for a film-forming apparatus, use was made of the same film-forming apparatus as was used in the case of the example 1 (A). That is, a layout was adopted such that lines of magnetic forces of evaporation sources adjacent to each other are caused to be joined together, as shown in Fig. 1.

Results of measurements described as above (the deposition rate of the DLC film, as found), together with film-forming conditions, are shown in Table 2. As is evident from Table 2, the duty cycle upon the impartation of the pulse potential in the respective cases of Nos. 4 to 6 is found in a range of 50 to 80%, the duty cycle in the respective cases of Nos. 1 to 3 is found less than 50%, and the duty cycle in the respective cases of Nos. 7 to 9 is found exceeding 80%. It is shown that the deposition rate of the DLC film in the respective cases of Nos. 4 to 6 is found higher in comparison with that in the respective cases of Nos. 1 to 3 and in the respective cases of Nos. 7 to 9, showing that the DLC film is formed at high speeds, respectively.

## [Example 3]

With the use of an apparatus shown in Fig. 3, comprising three units of unbalanced magnetron sputtering evaporation sources, and one unit of an arc-discharge evaporation source, deposition of an intermediate layer was carried out, and subsequently, deposition of a DLC film (containing metal or ceramics) in an atmosphere of a mixed gas of argon and a hydrocarbon gas was carried out in a pulse mode.

In this case, among the three units of the unbalanced magnetron sputtering evaporation sources (evaporation sources a to c), a chromium metal target for forming an intermediate layer was used for the evaporation source a, a solid carbon target was used for the evaporation source b, and any among a variety of metals or ceramics is attached to the evaporation source c. At the time of deposition of a DLC film, a layout was adopted such that lines of magnetic forces of evaporation sources adjacent to each other are caused to be joined together, as shown in Fig. 3.

For a matrix, use was made of a silicon wafer. A chromium metal film (100 nm) as the intermediate layer was formed on the silicon wafer as with the case of the example 1 (A). An atmosphere at the time of forming the intermediate layer composed of Cr metal was an argon atmosphere at a pressure of 0.6 Pa, as with the case of the example 1 (A).

After formation of the intermediate layer composed of a Cr metal, the evaporation source b (the solid carbon target), and the evaporation source c (metal or ceramics evaporation source) are caused to undergo concurrent discharge, thereby having deposited the DLC film containing the metal or the ceramics. In this case, an input power to the evaporation source b (the solid carbon target) was set to 2 kW at a pulse peak, as with the case of the example 1 (A), and an input power to the evaporation source c (metal or ceramics evaporation source) was set to 0.1 kW. An atmosphere at the time of film-deposition was at a total pressure of 0. 6 Pa, kept constant, as with the case of the example 1 (A), and a hydrocarbon gas was introduced at 10 % of a volumetric ratio, namely, at a partial pressure of 0.06 Pa, thereby having deposited the DLC film.

After the deposition of the DLC film, measurement of a film thickness of the DLC film was executed by observation of the cross section thereof in the same manner as in the case of the example 1 (A) as above, and a deposition rate of the DLC film was computed.

Results of measurements described as above (the deposition rate of the DLC film, as found), together with film-forming conditions, are shown in Table 3. All pieces denoted Nos. 1 to 7, respectively, shown in Table 3, represent the working examples, but differ from each other in respect of metal variety and ceramics variety, contained in the DLC film. In any of the cases of Nos. 1 to 7, respectively, it is shown that the DLC film is formed at high speeds as with the respective cases of Nos. 4 to 8, and No. 11, in Table 1.

Table 1

| | No. | target | Hydrocarbon gas | Partial pressure | Total pressure | Pulse frequency | Pulse mode | Duty | Deposition rate | |
|---|---|---|---|---|---|---|---|---|---|---|
| | | | | Pa | Pa | kHz | | % | μm/h | |
| magnetic force lines joined | 1 | C | - | 0 | 0.6 | 0 | DC | 100 | 0.12 | comparative example |
| | 2 | C | CH4 | 0.06 | 0.6 | 0 | DC | 100 | 0.30 | comparative example |
| | 3 | C | CH4 | 0.06 | 0.6 | 30 | unipolar | 70 | 0.29 | comparative example |
| | 4 | C | CH4 | 0.06 | 0.6 | 60 | unipolar | 70 | 0.42 | working example |
| | 5 | C | CH4 | 0.06 | 0.6 | 100 | unipolar | 70 | 0.45 | working example |
| | 6 | C | CH4 | 0.06 | 0.6 | 200 | unipolar | 70 | 0.51 | working example |
| | 7 | C | CH4 | 0.06 | 0.6 | 300 | unipolar | 70 | 0.52 | working example |
| | 8 | C | CH4 | 0.06 | 0.6 | 400 | unipolar | 70 | 0.50 | working example |
| | 9 | C | CH4 | 0.06 | 0.6 | 450 | unipolar | 70 | 0.30 | comparative example |
| | 10 | C | - | 0 | 0.6 | 200 | unipolar | 70 | 0.23 | comparative example |
| | 11 | C | CH4 | 0.06 | 0.6 | 200 | bipolar | 70 | 0.45 | working example |
| magnetic force lines not joined | 12 | C | CH4 | 0.06 | 0.6 | 200 | unipolar | 70 | 0.28 | comparative example |
| | 13 | C | CH4 | 0.06 | 0.6 | 300 | unipolar | 70 | 0.29 | comparative example |
| | 14 | C | CH4 | 0.06 | 0.6 | 400 | unipolar | 70 | 0.30 | comparative example |

| | No. | target | Hydrocarbon gas | Partial pressure | Total pressure | Pulse frequency | Pulse mode | Duty | Deposition rate | |
|---|-----|--------|-----------------|------------------|----------------|-----------------|------------|------|-----------------|---|
| | | | | Pa | Pa | kHz | | % | $\mu$m/h | |
| | 15 | C | CH4 | 0.06 | 0.6 | 200 | bipolar | 70 | 0.25 | comparative example |

EP 1 741 801 B1

Table 2

| No. | Target | Hydro-carbon gas | Partial press | Total pressure | Pulse frequency | Pulse mode | Duty | Deposition rate |
|-----|--------|------------------|---------------|----------------|-----------------|------------|------|-----------------|
|     |        |                  | Pa            | Pa             | kHz             |            | %    | μm/h            |
| 1   | C      | CH4              | 0.06          | 0.6            | 300             | unipolar   | 20   | 0.13            |
| 2   | C      | CH4              | 0.06          | 0.6            | 300             | unipolar   | 35   | 0.15            |
| 3   | C      | CH4              | 0.06          | 0.6            | 300             | unipolar   | 47   | 0.17            |
| 4   | C      | CH4              | 0.06          | 0.6            | 300             | unipolar   | 60   | 0.47            |
| 5   | C      | CH4              | 0.06          | 0.6            | 300             | unipolar   | 75   | 0.51            |
| 6   | C      | CH4              | 0.06          | 0.6            | 300             | unipolar   | 78   | 0.48            |
| 7   | C      | CH4              | 0.06          | 0.6            | 300             | unipolar   | 88   | 0.31            |
| 8   | C      | CH4              | 0.06          | 0.6            | 300             | unipolar   | 95   | 0.3             |
| 9   | C      | CH4              | 0.06          | 0.6            | DC              | unipolar   | 100  | 0.303           |

Table 3

| No. | Target 1 | Target 2 | Target 3 | hydrocarbon gass | Partial pressure | Total pressure | Pulse frequency | Pulse mode | Duty | Deposition rate |
|---|---|---|---|---|---|---|---|---|---|---|
| | | | | | Pa | Pa | kHz | | % | $\mu$m/h |
| 1 | C | Cr | Cr | CH4 | 0.06 | 0.6 | 300 | unipolar | 70 | 0.53 |
| 2 | C | Cr | W | CH4 | 0.06 | 0.6 | 300 | unipolar | 70 | 0.51 |
| 3 | C | Cr | Ti | CH4 | 0.06 | 0.6 | 300 | unipolar | 70 | 0.52 |
| 4 | C | Cr | Mo | CH4 | 0.06 | 0.6 | 300 | unipolar | 70 | 0.52 |
| 5 | C | Cr | SiC | CH4 | 0.06 | 0.6 | 300 | unipolar | 70 | 0.51 |
| 6 | C | Cr | B4C | CH4 | 0.06 | 0.6 | 300 | unipolar | 70 | 0.51 |
| 7 | C | Cr | TiB2 | CH4 | 0.06 | 0.6 | 300 | unipolar | 70 | 0.53 |

## EP 1 741 801 B1

The method for forming the amorphous carbon film, according to the invention, is capable of enhancing the film-deposition rate of the amorphous carbon film, and forming the amorphous carbon film at a high speed, so that the invention is useful as it can be suitably used for the method for forming the amorphous carbon film to thereby attain enhancement in productivity of the amorphous carbon film.

## Claims

1. A method for forming an amorphous carbon film, comprising the steps of:

   preparing at least two units of unbalanced magnetron sputtering evaporation sources, or at least one unit each of the unbalanced magnetron sputtering evaporation source and a magnetic field applied arc-discharge evaporation source; and
   using a solid carbon as a sputtering target material of at least one unit of the unbalanced magnetron sputtering evaporation source among the evaporation sources in an atmosphere of a mixed gas of an inert gas for sputtering and a carbon-containing gas,

   wherein respective magnetic fields of the evaporation sources are reversed in polarity from a magnetic field of the evaporation source adjacent to the respective evaporation sources, and a pulse bias at a frequency in a range of 50 to 400 kHz is applied to the respective unbalanced magnetron sputtering evaporation sources.

2. The method for forming an amorphous carbon film, according to claim 1, wherein the pulse potential is imparted at a duty cycle in a range of 50 to 80 %.

## Patentansprüche

1. Verfahren zum Bilden eines amorphen Kohlenstofffilms, umfassend die Schritte:

   das Herstellen von mindestens zwei Einheiten von nicht-ausgeglichenen Magnetronsputter-Verdampfungsquellen oder mindestens einer Quelle von jeweils einer nicht-ausgeglichenen Magnetronsputter-Verdampfungsquelle und
   einer Bogenentladungs-Verdampfungsquelle mit angelegtem Magnetfeld, und
   das Verwenden eines festen Kohlenstoffs als einem Sputtertargetmaterial von mindestens einer Einheit der nicht-ausgeglichenen Magnetronsputter-Verdampfungsquelle unter den Verdampfungsquellen in einer Atmosphäre eines Gasgemisches eines inerten Gases zum Sputtern und eines kohlenstoffhaltigen Gases,

   wobei die Magnetfelder der Verdampfungsquellen jeweils umgekehrt in der Polarität von einem Magnetfeld der Verdampfungsquelle, angrenzend an die jeweiligen Verdampfungsquellen, sind und eine Pulsvorspannung mit einer Frequenz in einem Bereich von 50 bis 400 kHz an die jeweiligen nicht-ausgeglichenen Magnetronsputter-Verdampfungsquellen angelegt wird.

2. Verfahren zum Bilden eines amorphen Kohlenstofffilms gemäß Anspruch 1,
   wobei das Impulspotential bei einem Belastungszyklus in einem Bereich von 50 bis 80% übermittelt wird.

## Revendications

1. Procédé pour former une couche de carbone amorphe, comprenant les étapes qui consistent à :

   préparer au moins deux unités de sources d'évaporation-pulvérisation par magnétron déséquilibré,
   ou au moins une unité de chaque de la source d'évaporation-pulvérisation par magnétron déséquilibré et d'une source d'évaporation par décharge d'arc utilisant un champ magnétique appliqué ; et
   utiliser du carbone solide comme matériau cible de pulvérisation d'au moins une unité de la source d'évaporation-pulvérisation par magnétron déséquilibré parmi les sources d'évaporation dans une atmosphère d'un mélange gazeux d'un gaz inerte pour la pulvérisation et d'un gaz contenant du carbone,
   où les polarités des champs magnétiques respectifs des sources d'évaporation sont inversées par rapport à un champ magnétique de la source d'évaporation adjacente aux sources d'évaporation respectives, et une polarisation d'impulsion à une fréquence se trouvant dans la plage de 50 à 400 kHz est appliquée aux sources d'évaporation-pulvérisation par magnétron déséquilibré respectives.

2. Procédé pour former une couche de carbone amorphe, selon la revendication 1, dans lequel le potentiel d'impulsions est transmis à un facteur de marche dans la plage de 50 à 80%.

# FIG.1

UNBALANCED MAGNETRON SPUTTERING EVAPORATION SOURCE

ARC-DISCHARGE EVAPORATION SOURCE

ARC-DISCHARGE EVAPORATION SOURCE

WORK IN PROCESS

UNBALANCED MAGNETRON SPUTTERING EVAPORATION SOURCE

EP 1 741 801 B1

# FIG.2

EP 1 741 801 B1

UNBALANCED MAGNETRON
SPUTTERING EVAPORATION
SOURCE

9    8    7

T₂

10A

S

6A

ARC-DISCHARGE
EVAPORATION
SOURCE

ARC-DISCHARGE
EVAPORATION
SOURCE

5A

11A

12A

4A

WORK IN
PROCESS

1    2    3    T₁

UNBALANCED MAGNETRON
SPUTTERING EVAPORATION
SOURCE

# FIG.3

UNBALANCED MAGNETRON SPUTTERING EVAPORATION SOURCE

UNBALANCED MAGNETRON SPUTTERING EVAPORATION SOURCE

ARC-DISCHARGE EVAPORATION SOURCE

WORK IN PROCESS

UNBALANCED MAGNETRON SPUTTERING EVAPORATION SOURCE

# F I G . 4

# F I G . 5

$$DUTY = \frac{Ton}{Ttotal} \times 100$$

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 247060 A